# EUROPEAN PATENT APPLICATION

(11) **EP 4 447 626 A1**
(43) Date of publication of application: **16.10.2024**
(21) Application number: 23167926.7
(22) Date of filing: 14.04.2023
(51) Int. Cl.: H05K 5/02, F21V 31/03

(54) **IMPROVED VENT AND VENT CASING**

(71) Applicant: W. L. Gore & Associates GmbH, 85640 Putzbrunn (DE)
(72) Inventor: GRUBER, Andreas, 85640 Putzbrunn (DE); STAUFER, Thomas, 85640 Putzbrunn (DE)
(74) Representative: HGF

(57) **Abstract**

There is described a vent comprising a vent housing, the vent housing comprising a top portion and a base portion and at least one exterior aperture, the base portion comprising a vent aperture covered by a membrane within the vent housing, the top portion being fixed to the base portion such that a channel is formed from the at least one exterior aperture to the vent aperture through the membrane such that during use gas may flow from the vent aperture through the membrane to the at least one exterior aperture through the channel, wherein at least one opening is defined between the top portion and the base portion within the channel between the at least one exterior aperture and the vent aperture and the at least one opening has a minimum dimension of less than 0.6 mm.

## Description

### Field

The present disclosure describes improved vents including improved vent housings that enclose a vent membrane.

### Background

Vents are used on enclosed containers to allow gas that may be generated within the enclosed container to be vented from the enclosed container to ensure that the pressure within the enclosed container does not exceed a threshold value above which there is a risk of breach of the enclosed container and its sealants.

Vents often include a vent housing that houses a vent membrane and protects that vent membrane from impact or from contamination. The integrity of the vent membrane is crucial to the function of the vent so that foreign species, such as particulates and liquids do not enter an enclosed container through the vent whilst also ensuring that gases can flow out of the closed container through the vent to ensure that dangerous pressures within the closed container are avoided. In addition, in at least some applications, such as where the enclosed container is a battery or an electronics housing, the vent membrane also ideally provides specificity to allow gases generated within the enclosed container to escape, whilst the ingress of other gases such as water vapour is minimised. Any damage to the vent membrane severely reduces the ability of the vent membrane to provide any specificity and can result in failure of the vent.

Accordingly, vents need to balance the ease of gas flow through the vent housing whilst minimising the ingress of liquids and particulates to maintain vent membrane performance. In addition, liquid water in contact with the vent membrane at least reduces the effectiveness of the vent membrane and so it is desirable to minimise the retention of liquid water within a vent housing after immersion or contact with liquid water, which requires larger apertures through which the liquid water can flow out of the vent housing.

Therefore, there is a need for improved vents having improved vent housings that protect the vent membrane from damage and from contact with liquid and particulates whilst also maximising the functionality of the vent membrane.

In addition, pests may be attracted into the vent housing and in at least some instances have been known to damage the vent membrane, at least impairing the functionality of the vent membrane and can lead to the entire vent needing to be replaced.

Accordingly, there is a need for improved vents and vent housings that at least reduce the ingress of pests into the vent housings.

At least some embodiments of the present disclosure are intended to at least partially address at least one of the above problems.

### Summary

According to a first aspect there is provided a vent comprising a vent housing, the vent housing comprising a top portion and a base portion and at least one exterior aperture, the base portion comprising a vent aperture covered by a membrane within the vent housing, the top portion being fixed to the base portion such that a channel is formed from the at least one exterior aperture to the vent aperture through the membrane such that during use gas may flow from the vent aperture through the membrane to the at least one exterior aperture through the channel, wherein at least one opening is defined between the top portion and the base portion within the channel between the at least one exterior aperture and the vent aperture and the at least one opening has a minimum dimension of less than 0.6 mm.

The channel may be defined between the base portion and the top portion. At least a portion of the channel may be defined between the base portion and the top portion. Accordingly, during use gas may flow from the vent aperture to the at least one exterior aperture along the channel through the at least one opening between the base portion and the top portion. The channel may be a pathway along which fluids may flow. The vent housing may comprise a plurality of channels. A channel may extend from the vent aperture to each of the at least one exterior aperture. Typically, each channel of the plurality of channels passes through the at least one opening. Each channel of the plurality of channels may include an opening of the at least one openings. Each channel of the plurality of channels may pass through the same at least one opening. Accordingly, it will be appreciated that any pathway from the vent aperture to any one of the at least one exterior apertures must pass through an opening of the at least one opening.

In some embodiments the at least one opening may correspond to a narrowing of the channel between the base portion and the top portion. The at least one opening may correspond to the narrowest point or portion of the channel. The at least one opening may correspond to the point or portion of the channel defined between the base portion and the top portion that has the smallest separation between the base portion and the top portion. The at least one opening may be defined adjacent to the vent aperture. The at least one opening may be defined adjacent to the exterior aperture. The at least one opening may be defined part way between the vent aperture and the exterior aperture.

The at least one opening may have a minimum dimension of less than 0.55 mm. The at least one opening may have a minimum dimension of less than 0.5 mm. The at least one opening may have a minimum dimension of less than 0.45 mm. The at least one opening may have a minimum dimension of less than 0.4 mm. The at least one opening may have a minimum dimension of less than 0.35 mm. The at least one opening may have a minimum dimension of less than 0.3 mm. The at least one opening may have a minimum dimension of less than 0.25 mm.

The at least one opening may be extended in at least one direction. The at least one opening may be a slit. The slit may extend in at least one direction. The at least one opening may extend at least partially around the vent aperture. The vent aperture may be circular. The at least one opening may extend at least 30 degrees around the vent aperture. The at least one opening may extend at least 45 degrees around the vent aperture. The at least one opening may extend at least 60 degrees around the vent aperture. The at least one opening may extend at least 90 degrees around the vent aperture. The at least one opening may extend at least 120 degrees around the vent aperture. The at least one opening may extend at least 180 degrees around the vent aperture. The at least one opening may extend at least 270 degrees around the vent aperture. The at least one opening may extend substantially around the vent aperture.

In embodiments where the at least one opening extends in at least one direction, the at least one opening may be configured to provide improved passage of liquid water through the at least one opening. Accordingly, during use, where the vent is immersed or exposed to liquid water, any liquid water that reaches the vent membrane may readily drain out of the vent. The at least one opening may be configured to prevent the ingress of pests into the vent housing or to the membrane within the vent housing. The at least one opening may have a minimum dimension that prevents or reduces the ingress of pests into the vent housing. The at least one opening may have a minimum dimension that prevents or reduces the ingress of pests to the vent membrane within the vent housing. The at least one opening may have a minimum dimension that is smaller than a maximum dimension of the pest.

The pest may include insects. The insects may include ants, flies, beetles, or the like. In particular the pest may be an ant such as *Monomorium intrudens,* for example. *Monomorium intrudens* have been found to go into vents and to bite through the venting membrane to gain access into the enclosed container. *Monomorium intrudens* are found in China, India, Japan and the USA. It will be appreciated by the person skilled in the art that the vent of the present aspect would be effective to prevent in the ingress of any suitably sized pests and that *Monomorium intrudens* is used herein as an exemplary pest.

Previous solutions that have been aimed to prevent the ingress of pests into vent housings to protect the vent membrane housed therein include the use of additional metal components as a barrier to the pests, as the pests typically will not or cannot bite through metal components to reach the interior of the closed container. However, the use of metal components or meshes increase the costs involved for the vent, extend the bill of materials, increase the complexity of integration and assembly of the vent. In addition, the combination of plastic materials and metal materials precent additional challenges under temperature changes due to the significantly different expansion coefficients of the materials involved.

In contrast, the vents of the present aspect include an at least one opening between a top portion and a bottom portion that has a smaller minimum dimension than the maximum dimension of the pest and have no requirement for the vent casing to include metal components. Accordingly, the vent of the present aspect may not comprise any metal or metallic components.

For example, *Monomorium intrudens* typically has a head that is about 0.3 mm wide and therefore, in order to prevent the ingress of this pest the at least one opening should be dimensioned appropriately. Accordingly, in embodiments where the at least one opening has a minimum dimension of less than 0.3 mm the at least one opening is smaller than the typical width of the head of *Monomorium intrudens* and therefore the *Monomorium intrudens* cannot get through the at least one opening. Accordingly, the vent membrane is protected from the pest.

The minimum dimension of the at least one opening may be less than 0.24 mm. The minimum dimension of the at least one opening may be less than 0.22 mm. The minimum dimension of the at least one opening may be less than 0.2 mm. The minimum dimension of the at least one opening may be less than 0.18 mm. The minimum dimension of the at least one opening may be less than 0.16 mm. The minimum dimension of the at least one opening may be less than 0.14 mm. The minimum dimension of the at least one opening may be less than 0.12 mm. The minimum dimension of the at least one opening may be less than 0.1 mm.

The minimum dimension of the at least one opening may be from 0.6 mm to 0.01 mm. The minimum dimension of the at least one opening may be from 0.6 mm to 0.05 mm. The minimum dimension of the at least one opening may be from 0.6 mm to 0.1 mm. The minimum dimension of the at least one opening may be from 0.6 mm to 0.2 mm. The minimum dimension of the at least one opening may be from 0.5 mm to 0.01 mm. The minimum dimension of the at least one opening may be from 0.4 mm to 0.01 mm. The minimum dimension of the at least one opening may be from 0.3 mm to 0.01 mm. The minimum dimension of the at least one opening may be from 0.25 mm to 0.01 mm.

The minimum dimension of the at least one opening may be from 0.24 mm to 0.01 mm. The minimum dimension of the at least one opening may be from 0.24 mm to 0.05 mm. The minimum dimension of the at least one opening may be from 0.25 mm to 0.1 mm. The minimum dimension of the at least one opening may be from 0.25 mm to 0.15 mm.

The top portion may comprise a top ridge and the at least one opening may be defined between the top ridge and the base portion. The top ridge may extend from the top portion toward the base portion. The top ridge may not contact the base portion where the at least one opening is defined. The top ridge may contact the base portion and the at least one opening may be defined by at least one indentation in the top ridge and the base portion.

The base portion may comprise a base ridge and the at least one opening may be defined between the top portion and the base ridge. The base ridge may extend from the base portion toward the top portion. The base ridge may not contact the top portion where the at least one opening is defined. The base ridge may contact the top portion and the at least one opening may be defined by at least one indentation in the base ridge and the top portion.

The top portion may comprise a top ridge and the base portion may comprise a base ridge. The top ridge may be configured to cooperate with the base ridge to thereby define the opening between the top ridge and the base ridge. The top ridge may extend toward the base ridge and the base ridge may extend toward the top ridge such that the at least one opening is defined between the top ridge and the base ridge. The top ridge may extend toward the base portion and the base ridge may extend toward the top portion such that the at least one opening is defined between the sides of the top ridge and the base ridge.

The top portion may comprise a plurality of top ridges. Each top ridge of the plurality of top ridges may be curved. Each top ridge of the plurality of top ridges may define an arc. Each top ridge of the plurality of top ridges may define portions of the same circle. Each top ridge of the plurality of top ridges may be linear. The plurality of top ridges may define a regular shape such as a triangle, square, rectangle, pentagon, hexagon, octagon etc. The base portion may comprise a plurality of base ridges. Each base ridge of the plurality of base ridges may be curved. Each base ridge of the plurality of base ridges may define an arc. Each base ridge of the plurality of base ridges may define portions of the same circle. Each top ridge of the plurality of top ridges may be linear. The plurality of top ridges may define a regular shape such as a triangle, square, rectangle, pentagon, hexagon, octagon etc. The top portion may comprise a plurality of top ridges and the base portion may comprise a plurality of base ridges and the plurality of top ridges may cooperate with the plurality of base ridges to define the at least one opening.

The top ridge may be annular. The base ridge may be annular. The top ridge and the base ridge may be annular. The base ridge may have a smaller radius than the top ridge. Accordingly, the base ridge may be positioned within the top ridge. The base ridge may have a larger radius than the top ridge. Accordingly, the top ridge may be positioned within the base ridge. The top ridge and the base ridge may be concentric or substantially concentric around the vent aperture.

Typically, the top ridge and the base ridge may have the same or similar shape. For example, the top ridge and the base ridge may both be circular, elliptical, triangular, square, rectangular, pentagonal, hexagonal, octagonal etc. The top ridge and the base ridge may have the same or similar dimensions. The top ridge and the base ridge may have different dimensions. The top ridge and the base ridge may be concentric or substantially concentric.

The at least one opening may comprise a plurality of openings. The plurality of openings may be arranged around the vent aperture. The plurality of openings may be arranged regularly around the vent aperture.

The plurality of openings may be defined between the top ridge and the base ridge.

In a second aspect there is provided an enclosed container comprising a container wall, the container wall defines an enclosed space and separates the interior of the enclosed container from the exterior of the enclosed container, the container wall comprising an aperture within which a vent according to the first aspect is installed.

The enclosed container may be a housing. The enclosed container may be an electronic housing or electronic enclosure. The electronic housing may be part of an electronic device. The enclosed container may be a housing of an acoustic device.

The enclosed container may be an electronic housing used in automotive applications. For example, the electronic housing may be a control unit, a lighting device a sensor device or similar.

The enclosed container may be an electronic housing used in outdoor applications such as mobile communication electronic installations or stations, solar cells or solar panels,

The enclosed container may be a housing for a battery. The enclosed container may be a battery pouch.

For the avoidance of doubt, features of the vent of the first aspect are features of the vent of the second aspect.

### Brief Description of the Figures

Embodiments of the present invention will now be described, by way of non-limiting example, with reference to the accompanying drawings.
**Figure 1****:** A cross section view of a vent according to an embodiment;
**Figure 2****:** A cross section view of a vent according to an embodiment;
**Figure 3****:** A horizontal cross section view of a vent according to an embodiment;
**Figure 4****:** An image of *Monomorium intrudens*;
**Figure 5****:** An image of a vent membrane that has been damaged by *Monomorium intrudens*;
**Figure 6****:** A cross section view of a vent according to an embodiment;
**Figure 7****:** A cross section view of a vent according to an embodiment;
**Figure 8****:** A cross section view of a vent according to an embodiment; and
**Figure 9****:** A cross section view of a vent according to an embodiment.

### Detailed Description

While the making and using of various embodiments of the present invention are discussed in detail below, it should be appreciated that the present invention provides many applicable inventive concepts that can be embodied in a wide variety of specific contexts. The specific embodiments discussed herein are merely illustrative of specific ways to make and use the invention and do not delimit the scope of the invention.

To facilitate the understanding of this invention, a number of terms are defined below. Terms defined herein have meanings as commonly understood by a person of ordinary skill in the areas relevant to the present invention. Terms such as "a", "an" and "the" are not intended to refer to only a singular entity, but include the general class of which a specific example may be used for illustration. The terminology herein is used to describe specific embodiments of the invention, but their usage does not delimit the invention, except as outlined in the claims.

Vents that are used to allow enclosed containers to be vented such that the pressure within the enclosed containers is maintained within acceptable levels are often subjected to physical challenges that can disrupt or degrade their performance. For example, liquids or particulates can contact the vent membranes that typically provide selectivity in the gases that can pass into or out of the enclosed container through the vent and degrade the performance of those vent membranes. Accordingly, it is important to prevent wherever possible the ingress of foreign species to maintain the performance of the vent. However, it is also necessary to allow the free passage of gases through the vent housing of the vent to ensure that gases are free to flow out of the enclosed container.

It is to be noted that the dimensions shown in the Figures are not to be taken to be to scale or in proportion necessarily and should not be construed as such unless specifically described as such.

### Example 1

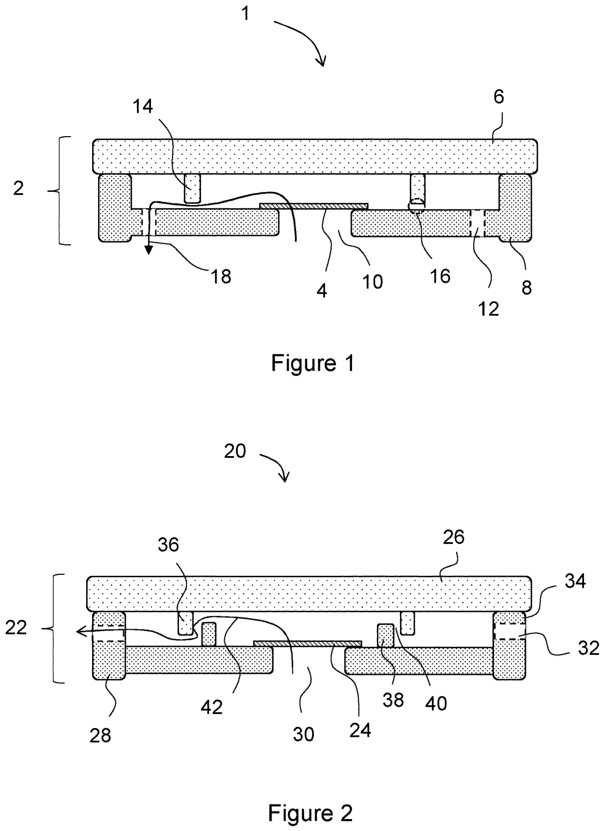

With reference to Figure 1 a vent 1 comprises vent casing 2 and a vent membrane 4 (acting as a membrane), the vent casing 2 comprises a top portion 6 and a bottom portion 8 (acting as a base portion). The bottom portion 8 comprises a central aperture 10 (acting as a vent aperture) and four exterior apertures (for example 12) arranged around the central aperture 10. The vent membrane 4 extends across and occludes the central aperture 10 and is positioned within the vent casing 2. The top portion 6 has a top ridge 14 that extends towards the bottom portion 8 and an opening 16 is formed between the top ridge 14 and the bottom portion 8. The top ridge 14 extends around the central aperture 10 and the opening 16 extends around the central aperture 10. The minimum distance between the top ridge 14 and the bottom portion 8 (i.e. the minimum distance of the opening 16) is 0.6 mm.

A pathway 18 (acting as a channel) is formed from the exterior apertures 12 to the central aperture 10 such that fluid may flow from the central aperture 10, through the vent membrane 4, through the opening 16 and out of the exterior apertures 12. Accordingly, during use gases generated within an enclosed container within which the vent 1 is installed can flow from within the enclosed container along the pathway out of the exterior apertures 12.

### Example 2

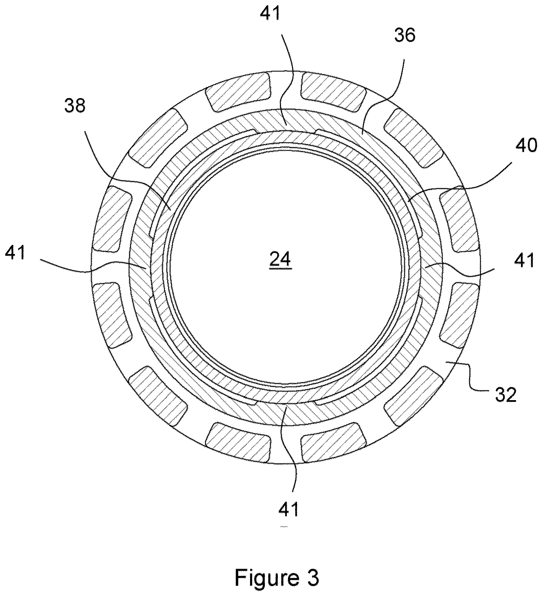

With reference to Figures 2 and 3 a vent 20 comprises a vent casing 22 and a membrane 24, the vent casing 22 comprises a top portion 26 and a base portion 28. The base portion 28 comprises a central aperture 30 (acting as a vent aperture) and six exterior apertures (for example 32) arranged around the central aperture 30 in the side wall 34 of the base portion 28. The membrane 24 extends across and occludes the central aperture 30 and is positioned within the vent casing 22. The top portion 26 has a top ridge 36 that extends towards the base portion 28. The base portion 28 comprises a base ridge 38. The base ridge 38 extends toward the top portion 26. An opening 40 is formed between the top ridge 36 and the base ridge 38. The top ridge 36 extends around the central aperture 30 and the opening 40 extends around the central aperture 30. The top ridge 36 is annular and extends around the central aperture 30 and includes spacers 41. The base ridge 38 is annular and extends around the top ridge 36. The minimum distance between the top ridge 36 and the base ridge 38 (i.e. the minimum distance of the opening 40) is 0.22 mm.

A pathway 42 (acting as a channel) is formed from the exterior apertures 32 to the central aperture 30 such that fluid may flow from the central aperture 30, through the membrane 24, through the opening 40 between the top ridge 36 and the base ridge 38 and out of the exterior apertures 32. Accordingly, during use gases generated within an enclosed container within which the vent 20 is installed can flow from within the enclosed container along the pathway out of the exterior apertures 32.

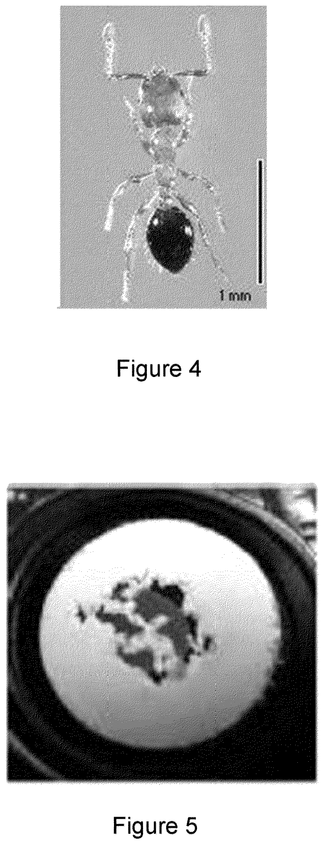

In addition to challenges from liquids and particulates, pests that can access the vent membrane can damage the vent membrane to thereby access the interior of the enclosed container. For example, *Monomorium intrudens* (see Figure 4) is a species of ant found in China, India, Japan and the USA that has been found to damage vent membranes, resulting in damaged vent membranes such as that shown in Figure 5.

The pathway of the vent 20 from the exterior apertures 32 through the vent casing 22 to the membrane 24 that a pest must follow includes the opening 40. Accordingly, pests that are bigger than 0.22 mm are unable to move past the opening 40 and so the membrane 24 is protected from the pest. For example, pests such as *Monomorium intrudens* are not able to reach the membrane 24.

Accordingly, the vent membrane 24 is protected from damage by both pests and other species such as liquids such as water and particulates, whilst also allowing sufficient gas flow out of an enclosed container within which the vent 20 is installed.

### Example 3

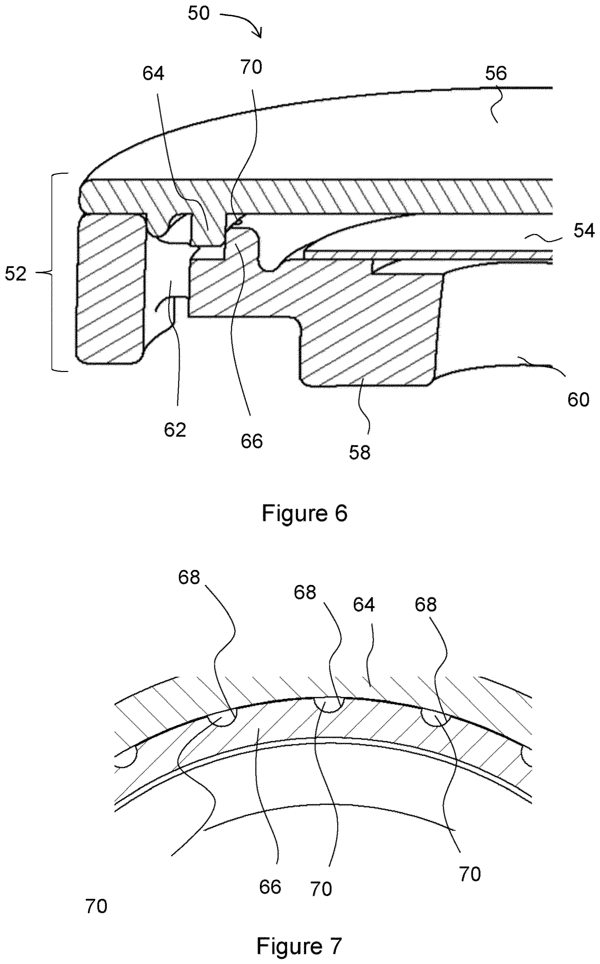

With reference to Figures 6 and 7, a vent 50 comprises a vent housing 52 and a vent membrane 54 (acting as a membrane). The vent housing 52 comprises a lid 56 (acting as a top portion), a base 58 (acting as a base portion), a vent aperture 60 and eight exterior apertures (for example aperture 62) arranged around the vent aperture 60. The vent membrane 54 extends over and occludes the vent aperture 60. The lid 56 comprises a lid ridge 64 (acting as a top ridge) that extends towards the base 58. The base 58 comprises a base ridge 66 that extends towards the lid 56. The side of the lid ridge 64 contacts the side of the base ridge 66. The base ridge 66 comprises a plurality of indentations 68 in the side of the base ridge 66 that contacts the side of the lid ridge 64 and that form a plurality of openings 70 between the base ridge 66 and lid ridge 64. The minimum dimension of each opening of the plurality of openings 70 is approximately 0.2 mm.

A channel is formed from the exterior apertures 62 to the vent aperture 60 such that fluid may flow from the central aperture 60, through the vent membrane 54, through the plurality of openings 70 between the lid ridge 64 and the base ridge 66 and out of the exterior apertures 62. Accordingly, during use gases generated within an enclosed container within which the vent 50 is installed can flow from within the enclosed container along the channel out of the exterior apertures 62.

As described above for Example 2, the provision of openings that have a minimum dimension of 0.2 mm prevents the ingress of pests into the vent housing 52 to the vent membrane 54 to thereby prevent damage to the vent membrane 54.

### Example 4

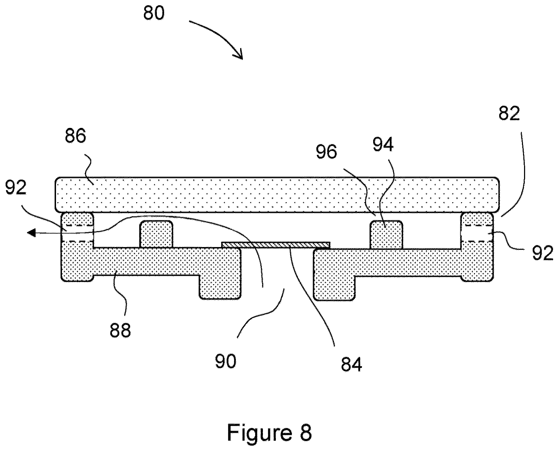

Figure 8 shows an alternative vent 80 comprises a vent housing 82 and a vent membrane 84 (acting as a membrane). The vent housing 82 comprises a lid 86 (acting as a top portion), a base 88 (acting as a base portion), a vent aperture 90 and eight exterior apertures (for example aperture 92) arranged around the vent aperture 90. The vent membrane 84 extends over and occludes the vent aperture 90. The base 88 comprises a base ridge 94 that extends towards the lid 86. The base ridge 94 forms an opening 96 between the base ridge 94 and the lid 86. The minimum dimension of the opening 96 is approximately 0.2 mm.

A channel is formed from the exterior apertures 92 to the vent aperture 90 such that fluid may flow from the vent aperture 90, through the vent membrane 84, through the opening 96 between the lid 86 and the base ridge 94 and out of the exterior apertures 92. Accordingly, during use gases generated within an enclosed container within which the vent 80 is installed can flow from within the enclosed container along the channel out of the exterior apertures 92.

As described above for Example 2, the provision of openings that have a minimum dimension of 0.2 mm prevents the ingress of pests into the vent housing 82 to the vent membrane 84 to thereby prevent damage to the vent membrane 84.

### Example 5

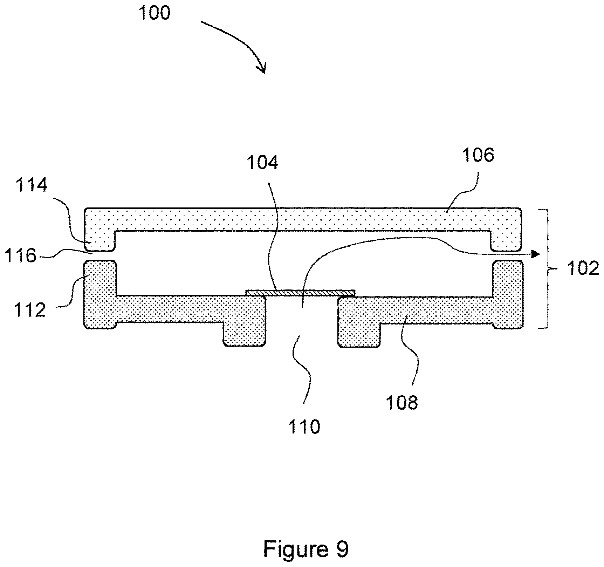

Figure 9 shows an alternative vent 100 comprises a vent housing 102 and a vent membrane 104 (acting as a membrane). The vent housing 102 comprises a cap 106 (acting as a top portion), a base 108 (acting as a base portion), and a vent aperture 110. The vent membrane 104 extends over and occludes the vent aperture 110. The base 108 comprises a base ridge 112 that extends towards the cap 106. The cap 106 comprises a cap ridge 114 that extends towards the base 108. An opening 116 is formed between the base ridge 112 and the cap ridge 114. The minimum dimension of the opening 116 is approximately 0.22 mm.

A channel is formed from opening 116 to the vent aperture 110 through the vent membrane 104 such that fluid may flow from the vent aperture 110, through the vent membrane 104, and out the opening 116 between the cap ridge 114 and the base ridge 112. Accordingly, during use gases generated within an enclosed container within which the vent 100 is installed can flow from within the enclosed container along the channel out of the opening 116.

As described above for Example 2, the provision of openings that have a minimum dimension of 0.22 mm prevents the ingress of pests into the vent housing 102 to the vent membrane 104 to thereby prevent damage to the vent membrane 104.

While there has been hereinbefore described approved embodiments of the present invention, it will be readily apparent that many and various changes and modifications in form, design, structure and arrangement of parts may be made for other embodiments without departing from the invention and it will be understood that all such changes and modifications are contemplated as embodiments as a part of the present invention as defined in the appended claims.

## Claims

1. A vent comprising a vent housing, the vent housing comprising a top portion and a base portion and at least one exterior aperture, the base portion comprising a vent aperture covered by a membrane within the vent housing, the top portion being fixed to the base portion such that a channel is formed from the at least one exterior aperture to the vent aperture through the membrane such that during use gas may flow from the vent aperture through the membrane to the at least one exterior aperture through the channel, wherein at least one opening is defined between the top portion and the base portion within the channel between the at least one exterior aperture and the vent aperture and the at least one opening has a minimum dimension of less than 0.6 mm.

2. The vent according to claim 1, wherein the minimum dimension of that at least one opening is of less than 0.3 mm.

3. The vent of claim 1, wherein the minimum dimension is from 0.3 mm to 0.05 mm.

4. The vent of any preceding claim, wherein the at least one opening extends at least partially around the vent aperture.

5. The vent of any preceding claim, wherein the top portion comprises a top ridge and the at least one opening is defined between the top ridge and the base portion.

6. The vent of claim 5, wherein the top ridge extends from the top portion toward the base portion.

7. The vent of claim 5 or claim 6, wherein the top ridge does not contact the base portion where the at least one opening is defined.

8. The vent of any preceding claim, wherein the base portion comprises a base ridge and the at least one opening is defined between the top portion and the base ridge.

9. The vent of claim 8, wherein the base ridge extends from the base portion toward the top portion.

10. The vent of any of claim 5 to claim 9, wherein the top portion comprises a top ridge and the base portion comprises a base ridge and the top ridge is configured to cooperate with the base ridge to thereby define the opening between the top ridge and the base ridge.

11. The vent of claim 10, wherein the top ridge is annular and the base ridge is annular and the top ridge and the base ridge are concentric around the vent aperture.

12. The vent of claim 11, wherein the base ridge has a smaller radius than the top ridge or the base ridge has a larger radius than the top ridge.

13. The vent of any preceding claim, wherein the at least one opening comprises a plurality of openings.

14. The vent of claim 13, wherein the plurality of openings are arranged around the vent aperture, optionally wherein the plurality of openings are arranged regularly around the vent aperture.

15. The vent of any of claim 13 to 14 when dependent on any of claims 10 to 12, wherein the plurality of openings are defined between the top ridge and the base ridge.
